# FASCICULE DE BREVET EUROPEEN

(11) **EP 2 702 632 B1**
(45) Date de publication et mention de la délivrance du brevet: **27.12.2017**
(21) Numéro de dépôt: 12717302.9
(22) Date de dépôt: 27.04.2012
(51) Int. Cl.: H01M 2/32, H01M 10/0525, H01M 10/44, H01M 10/48

(54) **PROCEDE DE SURVEILLANCE D'UNE BATTERIE LI-ION ET DISPOSITIF DE SURVEILLANCE POUR SA MISE EN OEUVRE**
VERFAHREN ZUR ÜBERWACHUNG EINER LI-IONENBATTERIE UND ÜBERWACHUNGSVORRICHTUNG ZUR IMPLEMENTIERUNG
METHOD FOR MONITORING A LI-ION BATTERY AND MONITORING DEVICE FOR THE IMPLEMENTATION THEREOF

(30) Priorité: 29.04.2011 FR 1153663
(43) Date de publication de la demande: 05.03.2014
(73) Titulaire: COMMISSARIAT À L'ÉNERGIE ATOMIQUE ET AUX ÉNERGIES ALTERNATIVES, 75015 Paris (FR); Université Joseph Fourier - Grenoble, 38041 Grenoble Cedex 9 (FR); Institut Polytechnique de Grenoble, 38000 Grenoble (FR)
(72) Inventeur: GENIES, Sylvie, F-38120 Saint Egrève (FR); BRUN-BUISSON, David, F-38470 Vatilieu (FR); KIRCHEVA, Nina, F-73100 Aix les Bains (FR); THIVEL, Pierre-Xavier, F-38000 Grenoble (FR)
(74) Mandataire: Novaimo
(86) Numéro de dépôt international: PCT/EP2012/057736
(87) Numéro de publication internationale: WO 2012/146704

(56) Documents cités:
- FR-A1- 2 949 908

## Description

La présente invention concerne le domaine des batteries d'accumulateurs de type lithium-ion ou Li-ion. En particulier, l'invention concerne un procédé de surveillance d'une cellule électrochimique ou d'une batterie. L'invention concerne aussi un procédé de charge comprenant une mise en oeuvre d'un tel procédé de surveillance. L'invention concerne aussi un procédé de fabrication d'une batterie comprenant une mise en oeuvre d'un tel procédé de charge. L'invention concerne aussi une batterie obtenue par la mise en oeuvre d'un tel procédé de fabrication. L'invention porte encore sur un dispositif de surveillance mettant en oeuvre le procédé de surveillance. L'invention porte enfin sur un système de charge comprenant un tel dispositif de surveillance.

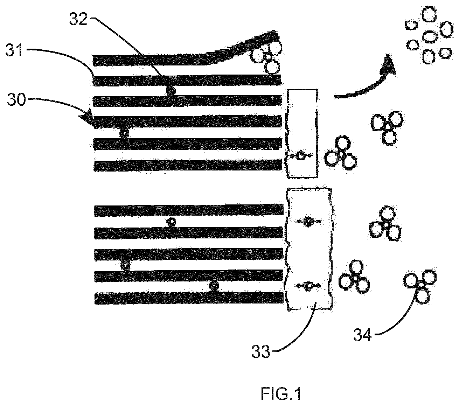

Comme représenté à la figure 1, dans les cellules électrochimiques utilisées dans les batteries du type Li-ion, on utilise une électrode en graphite 30, notamment une électrode négative en graphite. Il se produit au niveau de cette électrode, lors de la première réaction électrochimique, notamment la première charge, une formation d'une couche 33 ou d'un film de passivation. Ce film est produit par la décomposition, lors de la première charge de la cellule, de produits 34 contenus dans l'électrolyte comprenant des produits organiques et du sel de lithium. Cette décomposition permet la réalisation du film qui empêche les ions lithium associés à un solvant de pénétrer dans l'électrode. Ce film est appelé « interface solide-électrolyte » ou « SEI » (pour « Solid Electrolyte Interface » en anglais) par analogie à la couche de passivation pouvant être formée à la surface du lithium solide. Ce film est très important pour le fonctionnement futur de la batterie car il permet de protéger l'électrode de certaines réactions. En effet, grâce à ce film qui a une propriété d'isolant électronique et de conducteur ionique, il est possible de stocker et de déstocker de manière réversible des ions lithium 32 sans augmenter sensiblement les distances entre les différentes couches 31 ou strates de graphite de l'électrode. Le lithium est alors stocké entre les couches ou strates de graphite. Ainsi, on préserve la structure de l'électrode en graphite dans le temps et cette structure est suffisamment stable dimensionnellement pour permettre une longue durée de vie à la batterie. On assure ainsi la capacité maximale à la batterie.

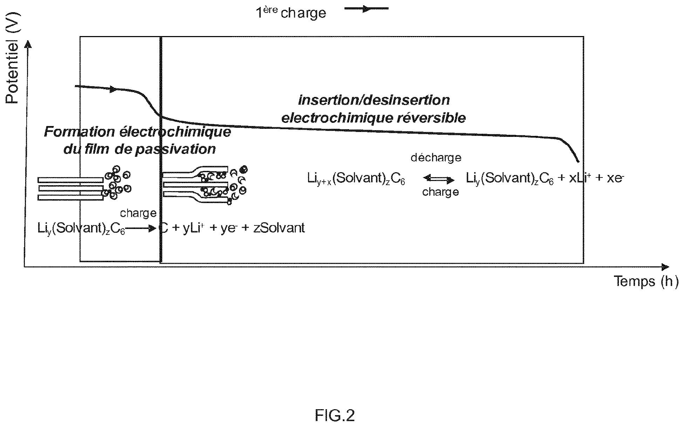

Ce phénomène de formation du film se produit lors de la première charge de la cellule électrochimique. Il est représenté sur le schéma de la figure 2.

Ce phénomène est étudié de manière connue en testant une demi-cellule graphite-lithium. Dans cette configuration particulière de cellules, l'électrode positive est réalisée en graphite et l'électrode négative est une feuille de lithium métallique. Ainsi, le premier stockage de lithium dans le graphite est réalisé durant la première décharge de la demi-cellule électrochimique, alors que le même phénomène se produit durant la charge de la cellule complète. Le phénomène est de cette manière observé de manière plus aisée car un palier est visible sur le profil de tension de la cellule durant sa décharge, ce palier correspondant à une réduction électrochimique de LiₓC₆ pour un potentiel de 0,8 V du couple Li⁺/Li à une tension supérieure où le lithium est stocké dans le graphite. La figure 2 représente le profil de tension de décharge d'une demi-cellule graphite-lithium. Le palier de formation du film SEI est bien visible lors de la première décharge pour un potentiel de 0,8 V du couple électrochimique Li⁺/Li. Ce palier n'est visible que lors de la première décharge et n'est plus présent lors des décharges suivantes. En effet, le film SEI est principalement formé lors de la première phase de stockage des ions lithium dans le graphite. Cette première phase est donc la plus importante et doit être correctement gérée afin de produire le meilleur film SEI possible, notamment en ce qui concerne son épaisseur, sa régularité, son état de surface, son étendue. C'est pourquoi il est habituel de réaliser la première charge à courant constant et de faible intensité.

Cette inflexion n'est pas discernable pour une cellule complète. En pratique, dans les batteries du commerce, la première charge de la batterie est réalisée par les fabricants avant que ceux-ci ne la vendent. Traditionnellement, cette charge est réalisée par application d'un courant constant jusqu'à ce que la batterie atteigne un seuil de tension. Il s'agit d'une charge galvanostatique. Comme vu précédemment, il est important de noter que le palier évoqué précédemment et correspondant à la phase de réalisation du film SEI n'est pas visible sur le profil de tension de première charge de la batterie.

Le document FR2949908A1 décrit un procédé de surveillance d'anomalie au sein d'un accumulateur. Le procédé comprend une analyse acoustique.

Le but de l'invention est de fournir un procédé de surveillance permettant de remédier aux problèmes évoqués précédemment et améliorant les procédés de surveillance connus de l'art antérieur. En particulier, l'invention propose un procédé de surveillance d'une batterie simple, non intrusif et peu coûteux. Le procédé de surveillance permet en outre la fabrication d'une batterie optimisée, la qualité de fabrication étant assurée tout en limitant le temps de fabrication.

Le procédé selon l'invention permet de surveiller charge d'une cellule électrochimique ou d'une batterie de type Li-ion. Le procédé comprend une étape d'acquisition de données relatives à des émissions acoustiques produites dans la cellule électrochimique ou dans la batterie et, en utilisant les données acquises, une étape de détection :
- de la formation d'un film de passivation sur une électrode de la cellule électrochimique ou de la batterie ; et/ou
- du premier stockage de lithium au niveau d'une électrode de la cellule électrochimique ou de la batterie.

L'étape de détection peut reposer sur la caractérisation des émissions acoustiques.

La caractérisation des émissions acoustiques peut reposer sur l'analyse d'une combinaison d'un ou plusieurs des paramètres suivants relatifs aux émissions acoustiques :
- nombre d'événements acoustiques ; et/ou
- amplitude d'un événement acoustique; et/ou
- énergie d'un événement acoustique; et/ou
- montée ou temps de montée d'un événement acoustique ; et/ou
- fréquence d'événements acoustiques; et/ou
- durée d'un événement acoustique.

On peut considérer qu'on détecte la formation d'un film de passivation sur une électrode de la cellule électrochimique ou de la batterie et/ou le premier stockage de lithium au niveau d'une électrode de la cellule électrochimique ou de la batterie lorsque la valeur de l'un des paramètres relatifs aux émissions acoustiques dépasse un seuil prédéterminé ou lorsque la valeur de la dérivée de l'un des paramètres relatifs aux émissions acoustiques dépasse un seuil prédéterminé.

On peut considérer que la formation d'un film de passivation sur une électrode de la cellule électrochimique ou de la batterie ou le premier stockage de lithium au niveau d'une électrode de la cellule électrochimique ou de la batterie est détecté ou en cours de réalisation lorsque la valeur d'au moins l'un des paramètres relatifs aux émissions acoustiques franchit un seuil prédéterminé.

On peut considérer qu'on détecte la fin de la formation d'un film de passivation sur une électrode de la cellule électrochimique ou de la batterie et/ou la fin du premier stockage de lithium au niveau d'une électrode de la cellule électrochimique ou de la batterie lorsque la valeur de l'un des paramètres relatifs aux émissions acoustiques franchit un seuil prédéterminé ou lorsque la valeur de la dérivée de l'un des paramètres relatifs aux émissions acoustiques franchit un seuil prédéterminé.

Le procédé selon l'invention permet de charger une cellule électrochimique ou une batterie de type Li-ion. Le procédé comprend une étape de surveillance de la cellule électrochimique ou de la batterie, par exemple une étape de mise en oeuvre du procédé de surveillance défini précédemment, et une étape de fonctionnement d'un dispositif de charge électrique de la cellule électrochimique ou de la batterie, le fonctionnement du dispositif de charge étant dépendant de la détection ou de l'absence de détection :
- de la formation d'un film de passivation sur une électrode de la cellule électrochimique ou de la batterie ; et/ou
- du premier stockage de lithium au niveau d'une électrode de la cellule électrochimique ou de la batterie.

On peut charger la cellule électrochimique ou la batterie avec un premier courant de charge avant de détecter la formation d'un film de passivation sur une électrode de la cellule électrochimique ou de la batterie et/ou avant de détecter le premier stockage de lithium au niveau d'une électrode et on peut charger la cellule électrochimique ou la batterie avec un deuxième courant de charge lorsqu'on détecte la formation d'un film de passivation sur une électrode de la cellule électrochimique ou de la batterie et/ou lorsqu'on détecte le premier stockage de lithium au niveau d'une électrode.

L'intensité moyenne du deuxième courant peut être inférieure à l'intensité moyenne du premier courant, notamment l'intensité du deuxième courant est inférieure à 75 % de l'intensité du premier courant, voire inférieure à 50 % de l'intensité du premier courant.

On peut charger la cellule électrochimique ou la batterie avec un troisième courant de charge lorsqu'on ne détecte plus la formation d'un film de passivation sur une électrode de la cellule électrochimique ou de la batterie et/ou lorsqu'on ne détecte plus le premier stockage de lithium au niveau d'une électrode.

L'intensité moyenne du deuxième courant peut être inférieure à l'intensité moyenne du troisième courant, notamment l'intensité du deuxième courant est inférieure à 75 % de l'intensité du troisième courant, voire inférieure à 50 % de l'intensité du troisième courant.

L'intensité du troisième courant peut être égale ou peut être sensiblement égale à l'intensité du premier courant.

Le procédé selon l'invention permet de fabriquer une cellule électrochimique ou une batterie de type Li-ion. Le procédé comprend une étape de mise en oeuvre du procédé de charge défini précédemment.

Selon l'invention, une cellule électrochimique ou batterie est obtenue par la mise en oeuvre du procédé de fabrication défini précédemment.

Selon l'invention, un dispositif de surveillance d'une cellule électrochimique ou d'une batterie de type Li-ion, comprend des éléments matériels et/ou logiciels de mise en oeuvre du procédé de surveillance défini précédemment.

Les éléments matériels et/ou logiciel peuvent comprendre un élément d'acquisition de données relatives à des émissions acoustiques produites dans la cellule électrochimique ou dans la batterie et un élément de détection :
- de la formation d'un film de passivation sur une électrode de la cellule électrochimique ou de la batterie ; et/ou
- du premier stockage de lithium au niveau d'une électrode.

Selon l'invention, un système de charge d'une cellule électrochimique ou d'une batterie de type Li-ion, comprend un dispositif de surveillance défini précédemment et un dispositif de charge, le dispositif de charge étant piloté en fonction d'informations fournies par le dispositif de surveillance.

Les dessins annexés représentent, à titre d'exemple, un mode de réalisation d'un dispositif de surveillance selon l'invention.
La figure 1 est un schéma représentant le principe de formation du film de passivation et de stockage du lithium dans une électrode de graphite.
La figure 2 est un diagramme d'évolution du potentiel d'une demi-cellule électrochimique au lithium au cours du temps.
La figure 3 est un schéma d'un mode de réalisation d'un système de charge électrique d'une cellule électrochimique ou d'une batterie selon l'invention
La figure 4 est un diagramme illustrant différents paramètres permettant de caractériser une émission acoustique.
Les figures 5 à 9 sont des diagrammes illustrant les corrélations existant entre des phénomènes physiques ou chimiques se produisant dans une cellule ou dans une batterie et des émissions acoustiques produites dans cette cellule ou cette batterie.
La figure 10 est un diagramme de l'évolution temporelle de l'intensité d'un courant de charge d'une batterie obtenu par la mise en oeuvre d'un procédé de charge selon l'invention.

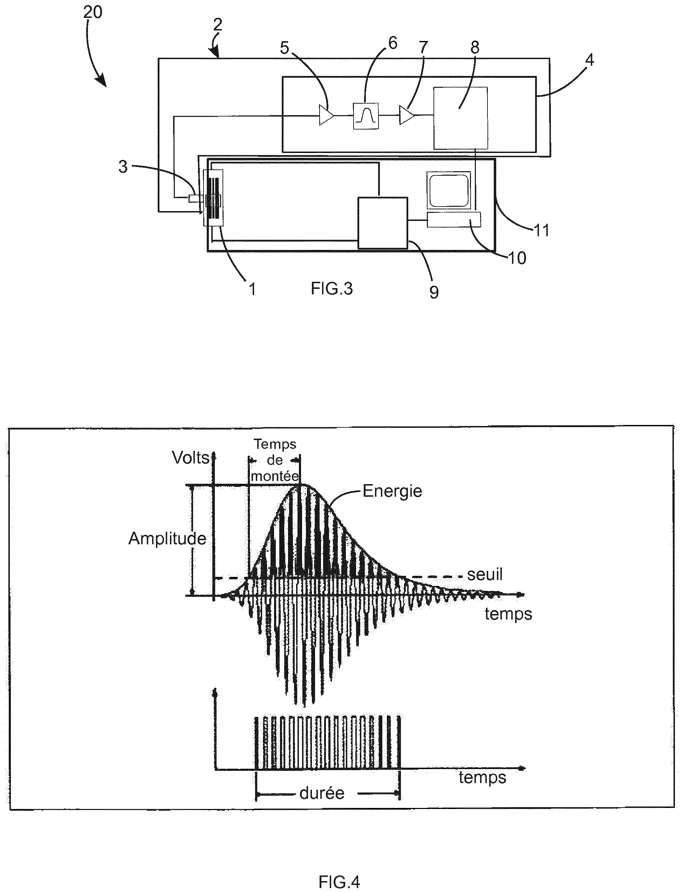

Un mode de réalisation d'un dispositif 2 de surveillance de la charge d'une cellule électrochimique ou d'une batterie 1 est décrit ci-après en référence à la figure 3. Ce dispositif de surveillance est destiné à surveiller la charge d'une cellule électrochimique ou d'une batterie de type Li-ion. Le dispositif de surveillance repose sur la détection et la caractérisation d'émissions acoustiques produites dans la cellule électrochimique ou dans la batterie lors de la charge, en particulier lors de la première charge. À cette fin, le dispositif de surveillance comprend principalement un capteur 3 et un dispositif 4 de traitement des signaux produits en sortie du capteur acoustique 3. Il peut être avantageux d'utiliser plusieurs capteurs pour fiabiliser la détection et/ou pour les répartir afin de disposer d'une surveillance spatiale.

Le capteur 3 est destiné à détecter les émissions acoustiques produites au sein de la cellule électrochimique ou au sein de la batterie 1 et de les transformer ou de les convertir en un signal, notamment en un signal électrique. À cette fin, le capteur est disposé de préférence au plus proche du lieu de production des émissions acoustiques. Par exemple, le capteur peut être disposé à proximité de la batterie ou de la cellule. En particulier, il est intéressant de disposer le capteur au niveau d'une paroi de la cellule ou de la batterie, par exemple sur une face de la cellule ou de la batterie. Ainsi, les émissions acoustiques peuvent arriver au niveau du capteur en traversant uniquement des composants de la cellule ou de la batterie. Le capteur peut donc être fixé sur la cellule ou sur la batterie. Le capteur peut être du type acoustique ou d'un autre type, comme un accéléromètre, l'important étant qu'il puisse détecter les émissions acoustiques produites dans la cellule ou la batterie et les transformer en un signal qui puisse être analysé. Le capteur peut être du type piezoélectrique. Notamment, le capteur permet de détecter et transformer des émissions acoustiques dont la fréquence est comprise entre 1 kHz et 3 MHz, en particulier entre 50 kHz et 1.5 MHz.

Le signal obtenu en sortie du capteur est fonction du phénomène générant les émissions acoustiques, de la transmission des émissions acoustiques dans la cellule ou dans la batterie jusqu'au capteur et de la transformation par le capteur du signal en un signal de sortie.

Le signal de sortie du capteur ou le signal produit par le capteur attaque ensuite un élément de traitement du signal 4. Par exemple, cet élément de traitement du signal comprend un préamplificateur 5 et/ou un filtre, notamment un filtre passe bas et/ou un filtre passe bande et/ou un filtre passe haut et/ou un amplificateur 7 et/ou un élément de mise en forme et/ou de détection d'événements.

Cet élément de traitement permet de caractériser les émissions acoustiques détectées dans la cellule ou dans la batterie et d'en déduire ce qui s'y passe, notamment de déduire qu'un film SEI est en train de se former sur une électrode négative, en particulier une électrode négative en graphite. L'élément de traitement permet également de déduire que du lithium est en train d'être stocké pour la première fois dans le graphite de l'électrode négative. Bien entendu, cet élément de traitement comprend pour ce faire un élément d'analyse du signal attaquant l'élément de traitement et fourni, par exemple, par l'amplificateur 7. Par ailleurs, l'élément de traitement utilise des valeurs de paramètres, comme des seuils, permettant de définir des conditions dans lesquelles on observe un événement donné comme la formation du film SEI et/ou le premier stockage de lithium dans l'électrode négative.

Une fois un événement détecté, le dispositif de surveillance 2, en particulier l'élément de traitement, transmet à un dispositif 11 de charge de la cellule électrochimique ou de la batterie une information traduisant l'existence de cet événement. L'information est en particulier transmise à une unité de commande du dispositif de charge. L'unité de commande 10 peut par exemple comprendre un ordinateur ou un calculateur. En particulier, l'unité de commande 10 pilote un chargeur 9 permettant de charger la cellule électrochimique ou la batterie avec un courant électrique. Un tel chargeur comprend avantageusement un générateur de courant de charge. L'unité de commande permet de piloter le chargeur 9 en fonction des événements détectés par le dispositif de surveillance 2.

Le dispositif de surveillance comprend tous les éléments matériels et/ou logiciels permettant de mettre en oeuvre le procédé de surveillance objet de l'invention. En particulier, il comprend un élément 3 d'acquisition de données relatives à des émissions acoustiques produites dans la cellule électrochimique ou dans la batterie et un élément 4, 8 de détection :
- de la formation d'un film de passivation sur une électrode de la cellule électrochimique ou de la batterie ; et/ou
- du premier stockage de lithium au niveau d'une électrode.

Une partie de l'élément d'acquisition peut comprendre des moyens logiciels. De même, tout ou partie de l'élément de détection peut comprendre des moyens logiciels.

Un premier mode d'exécution d'un procédé de surveillance d'une cellule électrochimique ou d'une batterie 1 selon l'invention est décrit ci-après. Il permet de surveiller notamment la première charge d'une cellule électrochimique ou d'une batterie de type Li-ion.

Dans une première étape, on acquiert ou on recueille des données relatives à des émissions acoustiques produites dans la cellule électrochimique ou dans la batterie. Cette acquisition est par exemple réalisée au moyen de l'élément d'acquisition 3 pouvant comprendre un capteur comme évoqué précédemment. Lors du fonctionnement d'une cellule électrochimique ou d'une batterie, en particulier lors de la première charge d'une cellule électrochimique ou d'une batterie, il se produit des phénomènes chimiques et/ou physiques, notamment des réactions chimiques. Lors de la formation du film SEI, il se produit notamment une précipitation de produits solides et un dégagement gazeux au niveau de la surface de l'électrode de graphite. Ces phénomènes génèrent des émissions acoustiques. Ces émissions acoustiques sont situées dans le domaine audible et dans le domaine des ultrasons. Au moins, certaines de ces émissions acoustiques sont caractéristiques du phénomène chimique et/ou physique se produisant. Cette acquisition se fait via un élément d'acquisition comme décrit précédemment qui produit un signal, notamment un signal électrique, représentatif des émissions acoustiques. Ce signal comprend les données acoustiques. Le signal est ensuite mis en forme notamment amplifié et/ou filtré avant d'être analysé au niveau d'un élément d'analyse inclus dans l'élément de détection.

Ainsi, une fois les données acoustiques acquises ou recueillies, on les analyse ou on les traite au niveau de l'élément de détection afin de déterminer ou détecter quel événement ou phénomène est en train de se dérouler dans la cellule ou dans la batterie et, en particulier, afin de déterminer ou détecter si un phénomène particulier, comme une formation d'un film de passivation sur une électrode de la cellule électrochimique ou de la batterie et/ou un premier stockage de lithium au niveau d'une électrode de la cellule électrochimique ou de la batterie est en train de se produire dans la cellule électrochimique ou la batterie.

Ainsi, on utilise les données acquises, pour détecter :
- la formation d'un film de passivation sur une électrode de la cellule électrochimique ou de la batterie ; et/ou
- le premier stockage de lithium au niveau d'une électrode de la cellule électrochimique ou de la batterie.

L'analyse, et donc la détection, repose sur la caractérisation des émissions acoustiques. Ainsi, de préférence, on analyse une combinaison d'un ou plusieurs des paramètres suivants relatifs aux émissions acoustiques :
- nombre d'événements acoustiques ; et/ou
- amplitude d'un événement acoustique; et/ou
- énergie d'un événement acoustique; et/ou
- montée ou temps de montée d'un événement acoustique ; et/ou
- fréquence d'événements acoustiques; et/ou
- durée d'un événement acoustique,
pour caractériser les émissions acoustiques et en déduire l'existence ou l'absence de phénomène particulier. Ces différents paramètres sont représentés sur le graphique de la figure 4 représentant une émission acoustique ou un événement. Il est à noter que deux types de fréquences peuvent servir à caractériser les émissions : la fréquence de survenue de l'émission acoustique et la fréquence des pics ou oscillations composant l'émission.

De préférence, on considère que la formation d'un film de passivation sur une électrode de la cellule électrochimique ou de la batterie ou le premier stockage de lithium au niveau d'une électrode de la cellule électrochimique ou de la batterie est détecté ou en cours de réalisation lorsque la valeur d'au moins l'un des paramètres relatifs aux émissions acoustiques franchit un seuil prédéterminé. Un ou plusieurs seuils doivent donc être préalablement enregistrés dans l'élément de détection pour permettre la caractérisation. De préférence, un seuil d'amplitude (représenté à la figure 4) est utilisé pour permettre la définition de certains paramètres comme la montée ou la durée, ces paramètres n'étant mesurés que lorsque l'amplitude de l'émission acoustique est supérieure au seuil.

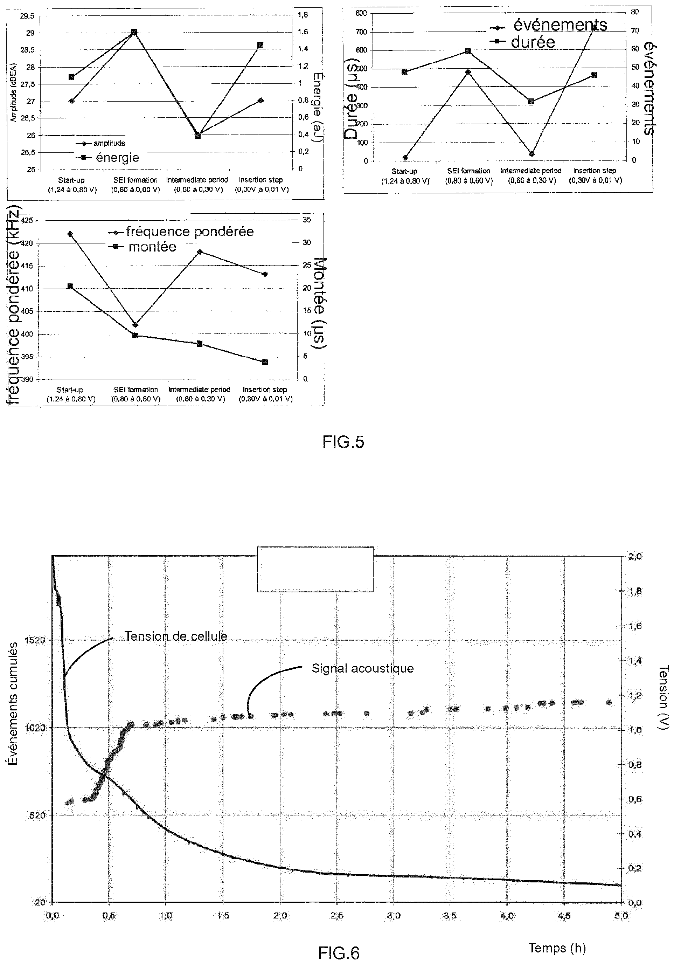

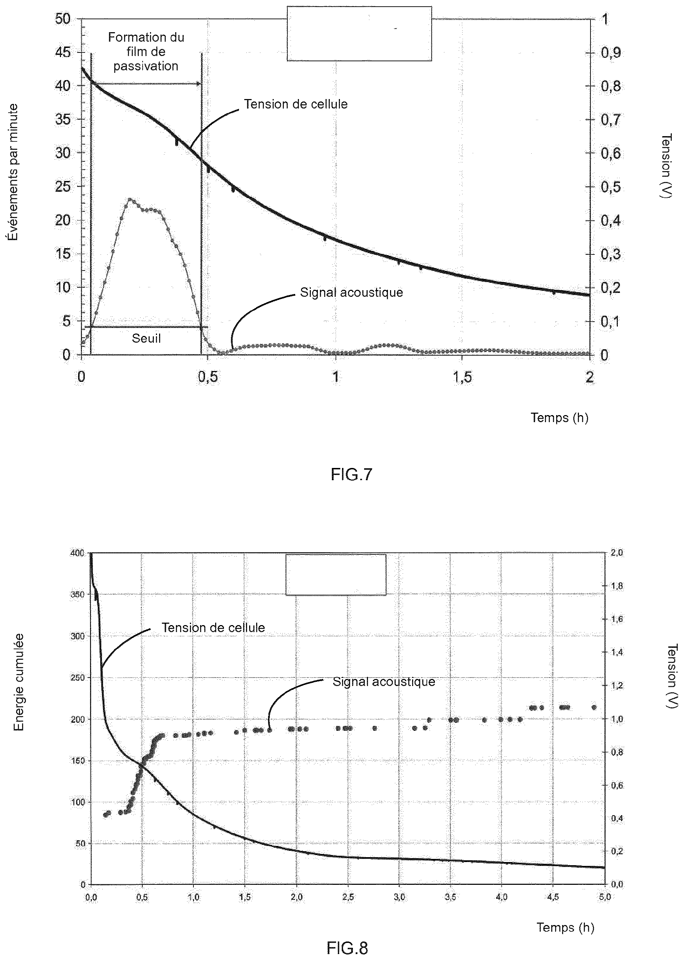

Par exemple, on peut utiliser, comme critère de détection de la formation d'un film de passivation ou du premier stockage du lithium, le nombre d'événements acoustiques détectés. Notamment, on peut considérer qu'il y a détection dès qu'un nombre d'événements acoustiques par intervalle de temps franchit un seuil à la hausse, par exemple varie de plus de 5% par rapport à un nombre d'événements acoustique par intervalle de temps donné. Ceci est illustré par les figures 6 et 7. La courbe de signal acoustique de la figure 7 représente en fait la dérivée de la courbe de nombres d'événements du signal acoustique de la figure 6. On peut aussi considérer qu'il y a détection lorsque la dérivée du nombre d'événements par unité de temps dépasse une valeur seuil, par exemple 5 événements acoustiques par minute.

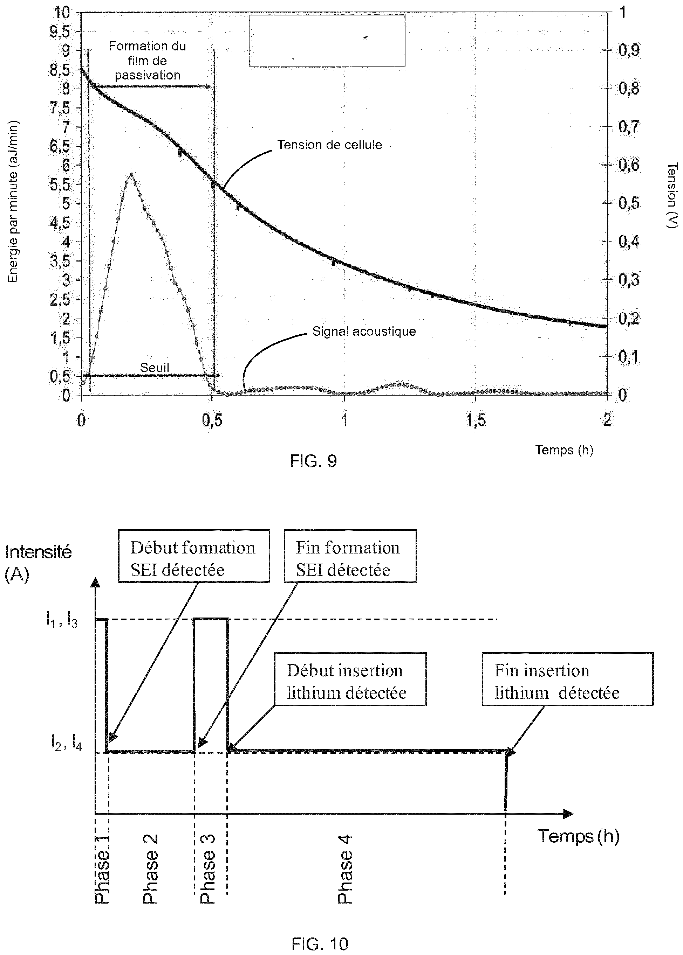

De la même manière, on peut utiliser l'énergie cumulée et sa dérivée dont les évolutions sont représentées aux figures 8 et 9. Notamment, on peut considérer qu'il y a détection dès qu'une énergie cumulée par intervalle de temps franchit un seuil à la hausse, par exemple varie de plus de 5% par rapport à une énergie cumulée par intervalle de temps donné. Ceci est illustré par les figures 8 et 9. La courbe de signal acoustique de la figure 9 représente en fait la dérivée de la courbe d'énergie cumulée du signal acoustique de la figure 8. On peut aussi considérer qu'il y a détection lorsque la dérivée de l'énergie cumulée dépasse une valeur seuil, par exemple 0,5.10⁻¹⁸ J/min.

De manière générale, on peut utiliser n'importe lequel ou n'importe quelle combinaison des six paramètres précédemment évoqués. En particulier, on peut considérer tout franchissement de seuil, en particulier, à la hausse ou à la baisse, d'un paramètre comme une détection. Notamment, toute augmentation de plus de 5% d'un paramètre peut être considérée comme une détection. Le seuil est défini avantageusement par rapport à un niveau d'un paramètre ou d'une combinaison de paramètres caractérisant un bruit de fond déterminé au début de la charge de la cellule ou de la batterie, c'est-à-dire avant le début de la formation du film de passivation et/ou avant le début du premier stockage de lithium.

Un premier mode d'exécution d'un procédé de charge d'une cellule électrochimique ou d'une batterie 1 selon l'invention est décrit ci-après. Il permet en particulier de réaliser la première charge d'une cellule électrochimique ou d'une batterie de type Li-ion.

Dans une première étape, on met en oeuvre le procédé de surveillance évoqué précédemment.

Simultanément, dans une deuxième étape, on charge la cellule électrochimique ou la batterie, notamment en faisant fonctionner le dispositif de charge 11. La charge ou le fonctionnement du dispositif de charge est dépendant de la détection ou de l'absence de détection :
- de la formation d'un film de passivation sur une électrode de la cellule électrochimique ou de la batterie ; et/ou
- du premier stockage de lithium au niveau d'une électrode de la cellule électrochimique ou de la batterie,
réalisée dans la première étape.

Avantageusement, dans une première phase de charge, on charge la cellule électrochimique ou la batterie avec un premier courant de charge avant de détecter la formation du film de passivation sur une électrode de la cellule électrochimique ou de la batterie et/ou avant de détecter le premier stockage de lithium au niveau d'une électrode, puis, dans une deuxième phase de charge, on charge la cellule électrochimique ou la batterie avec un deuxième courant de charge lorsqu'on détecte la formation d'un film de passivation sur une électrode de la cellule électrochimique ou de la batterie et/ou lorsqu'on détecte le premier stockage de lithium au niveau d'une électrode.

L'intensité du deuxième courant peut être inférieure à l'intensité du premier courant, notamment l'intensité du deuxième courant est inférieure à 75 % de l'intensité du premier courant, voire inférieure à 50 % de l'intensité du premier courant.

Enfin, dans une troisième phase de charge, on charge la cellule électrochimique ou la batterie avec un troisième courant de charge lorsqu'on ne détecte plus la formation d'un film de passivation sur une électrode de la cellule électrochimique ou de la batterie et/ou lorsqu'on ne détecte plus le premier stockage de lithium au niveau d'une électrode.

L'intensité du deuxième courant est inférieure à l'intensité du troisième courant, notamment l'intensité du deuxième courant est inférieure à 75 % de l'intensité du troisième courant, voire inférieure à 50 % de l'intensité du troisième courant.

De préférence, les intensités des premier et troisième courants sont égales ou sont sensiblement égales.

Un deuxième mode d'exécution du procédé de charge d'une cellule électrochimique ou d'une batterie 1 selon l'invention est décrit ci-après en référence à la figure 10. Il permet en particulier de réaliser la première charge d'une cellule électrochimique ou d'une batterie de type Li-ion.

Dans une première étape, on met en oeuvre le procédé de surveillance évoqué précédemment.

Simultanément, dans une deuxième étape, on charge la cellule électrochimique ou la batterie, notamment en faisant fonctionner le dispositif de charge 11. La charge ou le fonctionnement du dispositif de charge est dépendant de la détection ou de l'absence de détection :
- de la formation d'un film de passivation sur une électrode de la cellule électrochimique ou de la batterie ; et/ou
- du premier stockage de lithium au niveau d'une électrode de la cellule électrochimique ou de la batterie,
réalisée dans la première étape.

Avantageusement, dans une première phase de charge (Phase 1), on charge la cellule électrochimique ou la batterie avec un premier courant de charge avant de détecter la formation du film de passivation sur une électrode de la cellule électrochimique ou de la batterie, puis, dans une deuxième phase de charge (Phase 2), on charge la cellule électrochimique ou la batterie avec un deuxième courant de charge lorsqu'on détecte la formation d'un film de passivation sur une électrode de la cellule électrochimique ou de la batterie.

L'intensité du deuxième courant peut être inférieure à l'intensité du premier courant, notamment l'intensité du deuxième courant est inférieure à 75 % de l'intensité du premier courant, voire inférieure à 50 % de l'intensité du premier courant.

Dans une troisième phase de charge (Phase 3), on charge la cellule électrochimique ou la batterie avec un troisième courant de charge lorsqu'on ne détecte plus la formation d'un film de passivation sur une électrode de la cellule électrochimique ou de la batterie, jusqu'à ce qu'on détecte le premier stockage de lithium au niveau d'une électrode. Puis, dans une quatrième phase de charge (Phase 4), on charge la cellule électrochimique ou la batterie avec un quatrième courant de charge lorsqu'on détecte le premier stockage de lithium au niveau d'une électrode.

L'intensité du quatrième courant peut être inférieure à l'intensité du troisième courant, notamment l'intensité du quatrième courant est inférieure à 75 % de l'intensité du premier courant, voire inférieure à 50 % de l'intensité du troisième courant. Les intensités des premier et troisième courants peuvent être égales. Les intensités des deuxième et quatrième courants peuvent être égales.

De préférence, les intensités des premier et troisième courants sont égales ou sont sensiblement égales.

Les durées des phénomènes de formation du film et/ou de premier stockage du lithium sont courtes par rapport à la durée totale de la charge (de l'ordre du dixième de la durée totale de la charge). Le gain de temps de charge provient de la possibilité d'accélérer la charge, avec un courant de charge plus élevé, en dehors des phases où les phénomènes précédemment mentionnés se produisent. Ainsi, une batterie habituellement chargée en 20 heures peut être chargée en 10 heures. Pendant, les phases où les phénomènes précédemment mentionnés se produisent, l'intensité du courant de charge est réduite afin d'obtenir une structure de cellule de bonne qualité, en particulier de capacité optimisée.

Un premier mode d'exécution d'un procédé de fabrication d'une cellule électrochimique ou d'une batterie 1 selon l'invention est décrit ci-après. Il permet en particulier de réaliser une cellule électrochimique ou une batterie de type Li-ion.

Le procédé de fabrication comprend une étape de mise en oeuvre du procédé de charge décrit précédemment.

Enfin, l'invention porte aussi sur une cellule électrochimique ou batterie 1 obtenue par la mise en oeuvre du procédé de fabrication décrit précédemment.

Le procédé selon l'invention permet de gérer la formation du film de passivation ou SEI qui se produit sur l'électrode négative lors de la première charge de la cellule électrochimique ou lors de la première décharge de la demi-cellule graphite-lithium. Cette gestion est assurée à l'aide des émissions acoustiques produites au niveau de la cellule électrochimique. Un tel procédé est intéressant car il est non intrusif. En effet, un capteur de signaux acoustiques peut être simplement disposé sur la cellule électrochimique, notamment sur une des faces de la cellule électrochimique. En conséquence, il est possible de surveiller la première charge de la batterie, et donc la formation du film SEI sans modifier les étapes de réalisation ou de fabrication de la batterie. La mise en oeuvre du procédé est donc simple et peu coûteuse. Par ailleurs, il est possible de détecter les émissions acoustiques de manière fiable. En effet, même une activité acoustique faible due aux réactions électrochimiques internes à la cellule peut être détectée.

Du fait que les réactions électrochimiques sont particulières lors de la première charge de la cellule ou de la batterie, il est produit, lors de celle-ci, des émissions acoustiques particulières et différentes des émissions acoustiques produites lors des étapes suivantes de charge ou de décharge de la cellule ou de la batterie. En particulier, il peut être détecté à quel moment la réaction de formation du film SEI et/ou le premier stockage des ions lithium dans l'électrode se produit. Ainsi, il est possible de mettre en oeuvre des conditions de charge particulière à ces moments. Complémentairement, d'autres conditions de charge sont avantageusement mises en oeuvre en dehors de ces moments. De ce fait, il est possible d'améliorer sensiblement la qualité des cellules ou des batteries produites sans toutefois accroître la durée du procédé de fabrication des batteries ou des cellules.

Lors de tests, des signaux représentatifs des émissions acoustiques ont été enregistrés et sont représentés aux figures 5 à 9. Ces enregistrements ont été réalisés avec un système de surveillance comprenant un préamplificateur ayant un gain de 60 dB et un filtre passe bande de 100 kHz-1 MHz. Un seuil à 24 dB a été fixé : c'est au-delà de ce seuil que l'on considère qu'il y a une émission acoustique. L'intensité des courants de charge et de décharge a été fixée de sorte que la cellule ou la batterie serait complètement chargée ou complètement déchargée en 20 heures.

Pendant une première décharge à intensité constante durant laquelle le film SEI est formé alors que le potentiel est d'environ 0.8 V à 0.6 V, et durant laquelle a lieu un premier stockage de lithium entre des plans ou strates de l'électrode de graphite alors que le potentiel est d'environ 0.2 V à 0.01 V, de nombreuses émissions acoustiques peuvent être détectées.

Comme représenté à la figure 5, les phases de formation du film SEI et de premier stockage de lithium dans l'électrode de graphite d'une part et les émissions acoustiques (aussi appelées événements sur ces figures) peuvent être corrélées. La phase de formation du film SEI peut donc être détectée par l'analyse des émissions acoustiques.

Comme représenté aux figures 6 à 9, les évolutions des paramètres des émissions acoustiques pendant la décharge montrent que la phase de formation du film SEI peut, de son début jusqu'à sa fin, être détectée et donc être gérée en conséquence.

Il existe des batteries Li-ion présentant un matériau d'insertion du lithium. Dans ce cas, le phénomène de formation du film de passivation et le phénomène d'insertion du lithium apparaissent l'un après l'autre. Il y a d'abord le phénomène de formation du film, puis le phénomène d'insertion ou de stockage du lithium. Il est possible de surveiller uniquement le premier palier induit par le phénomène de formation du film ou de surveiller le palier induit par les phénomènes de formation du film et d'insertion du lithium.

Il existe aussi des batteries Li-ion présentant un matériau de conversion du lithium. Dans ce cas, seul le phénomène d'insertion du lithium existe. Il n'y a pas de phénomène de formation de film. Il est ici possible de surveiller le phénomène de stockage du lithium, soit de changement de la structure chimique du matériau.

## Revendications

1. Procédé de première charge d'une cellule électrochimique ou d'une batterie (1) de type Li-ion, comprenant une étape de surveillance de la cellule électrochimique ou de la batterie et une étape de fonctionnement d'un dispositif (11) de charge électrique de la cellule électrochimique ou de la batterie, le fonctionnement du dispositif de charge étant dépendant de la détection ou de l'absence de détection :
- de la formation d'un film de passivation sur une électrode de la cellule électrochimique ou de la batterie ; et/ou
- du premier stockage de lithium au niveau d'une électrode de la cellule électrochimique ou de la batterie, notamment au niveau d'une électrode en graphite,
l'étape de surveillance comprenant :
- une étape d'acquisition de données relatives à des émissions acoustiques produites dans la cellule électrochimique ou dans la batterie, et
- en utilisant les données acquises, une étape de détection, notamment une étape de détection reposant sur la caractérisation des émissions acoustiques :
∘ de la formation d'un film de passivation sur une électrode de la cellule électrochimique ou de la batterie ; et/ou
∘ du premier stockage de lithium au niveau d'une électrode de la cellule électrochimique ou de la batterie,
le procédé étant tel qu'on charge la cellule électrochimique ou la batterie avec un premier courant de charge avant de détecter la formation d'un film de passivation sur une électrode de la cellule électrochimique ou de la batterie et/ou avant de détecter le premier stockage de lithium au niveau d'une électrode et on charge la cellule électrochimique ou la batterie avec un deuxième courant de charge lorsqu'on détecte la formation d'un film de passivation sur une électrode de la cellule électrochimique ou de la batterie et/ou lorsqu'on détecte le premier stockage de lithium au niveau d'une électrode.

2. Procédé de charge selon la revendication précédente, **caractérisé en ce que** l'intensité moyenne du deuxième courant est inférieure à l'intensité moyenne du premier courant, notamment l'intensité du deuxième courant est inférieure à 75 % de l'intensité du premier courant, voire inférieure à 50 % de l'intensité du premier courant.

3. Procédé de charge selon la revendication 1 ou 2, **caractérisé en ce qu'**on charge la cellule électrochimique ou la batterie avec un troisième courant de charge lorsqu'on ne détecte plus la formation d'un film de passivation sur une électrode de la cellule électrochimique ou de la batterie et/ou lorsqu'on ne détecte plus le premier stockage de lithium au niveau d'une électrode.

4. Procédé de charge selon la revendication précédente, **caractérisé en ce que** l'intensité moyenne du deuxième courant est inférieure à l'intensité moyenne du troisième courant, notamment l'intensité du deuxième courant est inférieure à 75 % de l'intensité du troisième courant, voire inférieure à 50 % de l'intensité du troisième courant.

5. Procédé de charge selon la revendication 3 ou 4, **caractérisé en ce que** l'intensité du troisième courant est égale ou est sensiblement égale à l'intensité du premier courant.

6. Procédé de charge selon l'une des revendications précédentes, **caractérisé en ce que** la caractérisation des émissions acoustiques repose sur l'analyse d'une combinaison d'un ou plusieurs des paramètres suivants relatifs aux émissions acoustiques :
- nombre d'événements acoustiques ; et/ou
- amplitude d'un événement acoustique; et/ou
- énergie d'un événement acoustique; et/ou
- montée ou temps de montée d'un événement acoustique ; et/ou
- fréquence d'événements acoustiques; et/ou
- durée d'un événement acoustique.

7. Procédé de charge selon la revendication précédente, **caractérisé en ce qu'**on considère qu'on détecte la formation d'un film de passivation sur une électrode de la cellule électrochimique ou de la batterie et/ou le premier stockage de lithium au niveau d'une électrode de la cellule électrochimique ou de la batterie lorsque la valeur de l'un des paramètres relatifs aux émissions acoustiques dépasse un seuil prédéterminé ou lorsque la valeur de la dérivée de l'un des paramètres relatifs aux émissions acoustiques dépasse un seuil prédéterminé et/ou **en ce qu'**on considère que la formation d'un film de passivation sur une électrode de la cellule électrochimique ou de la batterie ou le premier stockage de lithium au niveau d'une électrode de la cellule électrochimique ou de la batterie est détecté ou en cours de réalisation lorsque la valeur d'au moins l'un des paramètres relatifs aux émissions acoustiques franchit un seuil prédéterminé.

8. Procédé de charge selon l'une des revendications précédentes, **caractérisé en ce qu'**on considère qu'on détecte la fin de la formation d'un film de passivation sur une électrode de la cellule électrochimique ou de la batterie et/ou la fin du premier stockage de lithium au niveau d'une électrode de la cellule électrochimique ou de la batterie lorsque la valeur de l'un des paramètres relatifs aux émissions acoustiques franchit un seuil prédéterminé ou lorsque la valeur de la dérivée de l'un des paramètres relatifs aux émissions acoustiques franchit un seuil prédéterminé.

9. Procédé de fabrication d'une cellule électrochimique ou d'une batterie comprenant une étape de mise en oeuvre du procédé de charge selon l'une des revendications 1 à 8.

10. Système (20) de charge d'une cellule électrochimique ou d'une batterie, notamment système de première charge d'une cellule électrochimique de type Li-ion ou d'une batterie de type Li-ion, comprenant un dispositif de surveillance (2) et un dispositif de charge (11), le dispositif de surveillance comprenant un élément (3) d'acquisition de données relatives à des émissions acoustiques produites dans la cellule électrochimique ou dans la batterie et un élément (4, 8) de détection le dispositif de charge étant piloté en fonction d'informations fournies par le dispositif de surveillance, le fonctionnement du dispositif de charge étant dépendant de la détection ou de l'absence de détection :
- de la formation d'un film de passivation sur une électrode de la cellule électrochimique ou de la batterie ; et/ou
- du premier stockage de lithium au niveau d'une électrode de la cellule électrochimique ou de la batterie.

## Patentansprüche

1. Verfahren zum ersten Laden einer elektrochemischen Zelle oder einer Batterie (1) des Typs der Li-Ionenbatterie, umfassend einen Schritt des Überwachens der elektrochemischen Zelle oder der Batterie und einen Schritt des Betreibens einer Vorrichtung (11) zum elektrischen Laden der elektrochemischen Zelle oder der Batterie, wobei das Betreiben der Ladevorrichtung abhängig ist von dem Erkennen oder dem Nichterkennen:
- der Bildung einer Passivierungsschicht auf einer Elektrode der elektrochemischen Zelle oder der Batterie und/oder
- der ersten Speicherung von Lithium an einer Elektrode der elektrochemischen Zelle oder der Batterie, insbesondere an einer Graphitelektrode,
wobei der Schritt des Überwachens Folgendes umfasst:
- einen Schritt des Erfassens von Daten über akustische Emissionen, die in der elektrochemischen Zelle oder der Batterie erzeugt werden, und
- unter Verwendung der erfassten Daten, einen Schritt des Erkennens, insbesondere einen Schritt des Erkennens, der auf der Charakterisierung der akustischen Emissionen beruht:
∘ der Bildung einer Passivierungsschicht auf einer Elektrode der elektrochemischen Zelle oder der Batterie und/oder
∘ der ersten Speicherung von Lithium an einer Elektrode der elektrochemischen Zelle oder der Batterie,
wobei das Verfahren derart ist, dass die elektrochemische Zelle oder die Batterie mit einem ersten Ladestrom geladen wird, bevor die Bildung einer Passivierungsschicht auf einer Elektrode der elektrochemischen Zelle oder der Batterie erkannt wird, und/oder bevor die erste Speicherung von Lithium an einer Elektrode erkannt wird, und die elektrochemische Zelle oder die Batterie mit einem zweiten Ladestrom geladen wird, wenn die Bildung einer Passivierungsschicht auf einer Elektrode der elektrochemischen Zelle oder der Batterie erkannt wird und/oder wenn die erste Speicherung von Lithium an einer Elektrode erkannt wird.

2. Verfahren zum Laden nach dem vorhergehenden Anspruch, **dadurch gekennzeichnet, dass** die mittlere Intensität des zweiten Stroms niedriger als die mittlere Intensität des ersten Stroms ist, insbesondere die Intensität des zweiten Stroms niedriger als 75 % der Intensität des ersten Stroms oder sogar niedriger als 50 % der Intensität des ersten Stroms ist.

3. Verfahren zum Laden nach Anspruch 1 oder 2, **dadurch gekennzeichnet, dass** die elektrochemische Zelle oder die Batterie mit einem dritten Ladestrom geladen wird, wenn keine Bildung einer Passivierungsschicht auf einer Elektrode der elektrochemischen Zelle oder der Batterie mehr erkannt wird und/oder wenn keine erste Speicherung von Lithium an einer Elektrode mehr erkannt wird.

4. Verfahren zum Laden nach dem vorhergehenden Anspruch, **dadurch gekennzeichnet, dass** die mittlere Intensität des zweiten Stroms niedriger als die mittlere Intensität des dritten Stroms ist, insbesondere die Intensität des zweiten Stroms niedriger als 75 % der Intensität des dritten Stroms oder sogar niedriger als 50 % der Intensität des dritten Stroms ist.

5. Verfahren zum Laden nach Anspruch 3 oder 4, **dadurch gekennzeichnet, dass** die Intensität des dritten Stroms gleich oder im Wesentlichen gleich der Intensität des ersten Stroms ist.

6. Verfahren zum Laden nach einem der vorhergehenden Ansprüche, **dadurch gekennzeichnet, dass** die Charakterisierung der akustischen Emissionen auf der Analyse von einer Kombination von einem oder mehreren der folgenden Parameter in Bezug auf die akustischen Emissionen beruht:
- Anzahl von akustischen Ereignissen und/oder
- Amplitude eines akustischen Ereignisses und/oder
- Energie eines akustischen Ereignisses und/oder
- Anstieg oder Anstiegszeit eines akustischen Ereignisses und/oder
- Häufigkeit von akustischen Ereignissen und/oder
- Dauer eines akustischen Ereignisses.

7. Verfahren zum Laden nach dem vorhergehenden Anspruch, **dadurch gekennzeichnet, dass** erachtet wird, dass die Bildung einer Passivierungsschicht auf einer Elektrode der elektrochemischen Zelle oder der Batterie erkannt wird und/oder die erste Speicherung von Lithium an einer Elektrode der elektrochemischen Zelle oder der Batterie erkannt wird, wenn der Wert von einem der Parameter in Bezug auf die akustischen Emissionen einen vorbestimmten Schwellenwert übersteigt oder wenn der Wert der Ableitung von einem der Parameter in Bezug auf die akustischen Emissionen einen vorbestimmten Schwellenwert übersteigt, und/oder dass erachtet wird, dass die Bildung einer Passivierungsschicht auf einer Elektrode der elektrochemischen Zelle oder der Batterie oder die erste Speicherung von Lithium an einer Elektrode der elektrochemischen Zelle oder der Batterie erkannt wird oder im Gange ist, wenn der Wert von mindestens einem der Parameter in Bezug auf die akustischen Emissionen einen vorbestimmten Schwellenwert überschreitet.

8. Verfahren zum Laden nach einem der vorhergehenden Ansprüche, **dadurch gekennzeichnet, dass** erachtet wird, dass das Ende der Bildung einer Passivierungsschicht auf einer Elektrode der elektrochemischen Zelle oder der Batterie erkannt wird und/oder das Ende der ersten Speicherung von Lithium an einer Elektrode der elektrochemischen Zelle oder der Batterie erkannt wird, wenn der Wert von einem der Parameter in Bezug auf die akustischen Emissionen einen vorbestimmten Schwellenwert übersteigt oder wenn der Wert der Ableitung von einem der Parameter in Bezug auf die akustischen Emissionen einen vorbestimmten Schwellenwert überschreitet.

9. Verfahren zur Herstellung einer elektrochemischen Zelle oder einer Batterie, das einen Schritt zum Umsetzen des Verfahrens zum Laden nach einem der Ansprüche 1 bis 8 umfasst.

10. System (20) zum Laden einer elektrochemischen Zelle oder einer Batterie, insbesondere System zum ersten Laden einer elektrochemischen Zelle des Typs der Li-Ionenzelle oder einer Batterie des Typs der Li-Ionenbatterie, umfassend eine Überwachungsvorrichtung (2) und eine Ladevorrichtung (11),
wobei die Überwachungsvorrichtung ein Element (3) zum Erfassen von Daten über akustische Emissionen,
die in der elektrochemischen Zelle oder der Batterie erzeugt werden, und ein Element (4, 8) zum Erkennen umfasst,
wobei die Ladevorrichtung in Abhängigkeit von Informationen gesteuert wird, die von der Überwachungsvorrichtung bereitgestellt werden, wobei das Funktionieren der Ladevorrichtung von dem Erkennen oder dem Nichterkennen:
- der Bildung einer Passivierungsschicht auf einer Elektrode der elektrochemischen Zelle oder der Batterie und/oder
- der ersten Speicherung von Lithium an einer Elektrode der elektrochemischen Zelle oder der Batterie
abhängig ist.

## Claims

1. Method for first charging an electrochemical cell or a battery (1) of Li-ion type, comprising a step of monitoring the electrochemical cell or the battery and a step of operating a device (11) for the electrical charging of the electrochemical cell or of the battery, the operation of the charging device being dependent on the detection or absence of detection:
- of the formation of a passivation film on an electrode of the electrochemical cell or of the battery; and/or
- of the first storage of lithium in an electrode of the electrochemical cell or of the battery, notably in a graphite electrode,
the step of monitoring comprising:
- a step of acquiring data relating to acoustic emissions produced in the electrochemical cell or in the battery and,
- by using the data acquired, a step of detecting, notably a step of detecting based on the characterization of the acoustic emissions:
∘ of the formation of a passivation film on an electrode of the electrochemical cell or of the battery; and/or
∘ of the first storage of lithium in an electrode of the electrochemical cell or of the battery
the method being such that the electrochemical cell or the battery is charged with a first charging current before detecting the formation of a passivation film on an electrode of the electrochemical cell or of the battery and/or before detecting the first storage of lithium in an electrode and in that the electrochemical cell or the battery is charged with a second charging current when the formation of a passivation film on an electrode of the electrochemical cell or of the battery is detected and/or when the first storage of lithium in an electrode is detected.

2. Charging method according to the preceding claim, **characterized in that** the mean intensity of the second current is lower than the mean intensity of the first current, in particular the intensity of the second current is less than 75% of the intensity of the first current, or even less than 50% of the intensity of the first current.

3. Charging method according to Claim 1 or 2, **characterized in that** the electrochemical cell or the battery is charged with a third charging current when the formation of a passivation film on an electrode of the electrochemical cell or of the battery is no longer detected and/or when the first storage of lithium in an electrode is no longer detected.

4. Charging method according to the preceding claim, **characterized in that** the mean intensity of the second current is lower than the mean intensity of the third current, in particular the intensity of the second current is less than 75% of the intensity of the third current, or even less than 50% of the intensity of the third current.

5. Charging method according to Claim 3 or 4, **characterized in that** the intensity of the third current is equal to or is substantially equal to the intensity of the first current.

6. Charging method according to one of the preceding claims, **characterized in that** the characterization of the acoustic emissions is based on the analysis of a combination of one or more of the following parameters relating to the acoustic emissions:
- number of acoustic events; and/or
- amplitude of an acoustic event; and/or
- energy of an acoustic event; and/or
- rise or rise time of an acoustic event; and/or
- frequency of acoustic events; and/or
- duration of an acoustic event.

7. Charging method according to the preceding claim, **characterized in that** the formation of a passivation film on an electrode of the electrochemical cell or of the battery and/or the first storage of lithium in an electrode of the electrochemical cell or of the battery is considered to be detected when the value of one of the parameters relating to the acoustic emissions exceeds a predetermined threshold or when the value of the derivative of one of the parameters relating to the acoustic emissions exceeds a predetermined threshold and/or **in that** the formation of a passivation film on an electrode of the electrochemical cell or of the battery or the first storage of lithium in an electrode of the electrochemical cell or of the battery is considered to be detected or in the process of being carried out when the value of at least one of the parameters relating to the acoustic emissions passes a predetermined threshold.

8. Charging method according to one of the preceding claims, **characterized in that** the end of the formation of a passivation film on an electrode of the electrochemical cell or of the battery and/or the end of the first storage of lithium in an electrode of the electrochemical cell or of the battery is considered to be detected when the value of one of the parameters relating to the acoustic emissions passes a predetermined threshold or when the value of the derivative of one of the parameters relating to the acoustic emissions passes a predetermined threshold.

9. Method for manufacturing an electrochemical cell or a battery comprising a step of implementing the charging method according to one of Claims 1 to 8.

10. System (20) for charging an electrochemical cell or a battery, in particular system for the first charging of an electrochemical cell of Li-ion type or of a battery of Li-ion type, comprising a monitoring device (2) and a charging device (11), the monitoring device comprising an element (3) for acquiring data relating to acoustic emissions produced in the electrochemical cell or in the battery and an element (4, 8) for detecting, the charging device being controlled as a function of information provided by the monitoring device, the operation of the charging device being dependent on the detection or absence of detection:
- of the formation of a passivation film on an electrode of the electrochemical cell or of the battery; and/or
- of the first storage of lithium in an electrode of the electrochemical cell or of the battery.
